# EUROPEAN PATENT APPLICATION

(11) **EP 0 577 109 A1**
(43) Date of publication of application: **05.01.1994**
(21) Application number: 93110468.1
(22) Date of filing: 30.06.1993
(51) Int. Cl.: C23C 14/28, H01L 41/12

(54) **Method for forming metal thin film by using laser beam**

(30) Priority: 01.07.1992 JP 199215/92
(71) Applicant: TOYOTA JIDOSHA KABUSHIKI KAISHA, Aichi-ken (JP)
(72) Inventor: Takayanagi, Noboru, Toyota Jidosha K.K., Toyota-shi, Aichi-ken (JP); Inuzuka, Hiroyuki, K.K. Toyoda Jidoshokki, Kariya-shi, Aichi-ken (JP); Taga, Yasunori, c/o K.K. Toyota Chuo, Nagakute-cho, Aichi-gun, Aichi-ken (JP); Ohwaki, Takeshi, c/o K.K. Toyota Chuo, Nagakute-cho, Aichi-gun, Aichi-ken (JP); Yamadera, Hideya, c/o K.K. Toyota Chuo, Nagakute-cho, Aichi-gun, Aichi-ken (JP); Akihama, Kazuhiro, c/o K.K. Toyota Chuo, Nagakute-cho, Aichi-gun, Aichi-ken (JP)
(74) Representative: Tiedtke, Harro, Dipl.-Ing.

(57) **Abstract**

A method for forming a film by a laser beam in which the laser beam is concentrated and irradiated to an irradiated object disposed in a vacuum vessel to emit vaporized particles, and in which the vaporized particles are deposited on a base material opposedly disposed with respect to the irradiated object. The irradiated object is made of metal, and the laser beam is irradiated to the irradiated object at an incident angle of less than 43 degrees. Therefore, the generation of the droplets from the irradiated object is effectively reduced, so that the average density of the mixed droplets in the film can be lowered.

## Description

### BACKGROUND OF THE INVENTION

### Field of the Invention

The present invention relates to a method for forming a metal thin film by using a laser beam.

### Description of the Related Art

Conventionally, an ion plating method or an ion beam method is known as a method for forming an electric conductor thin film, a dielectric thin film, a semiconductor thin film, a superconductor thin film, or a magnetic thin film. According to these methods, particles which are deposited to a base material are evaporated or ionized by the discharge or the gas plasma of inert gas such as argon. Therefore, in these methods, the surface of the base material is washed to improve the adhesion, and the materiality control such as the crystallization of the film is effectively achieved. However, impurities of the inert gas are likely to be mixed into the film.

Recently, a method for forming the film by using a laser beam is disclosed in Japanese Laid-Open Patent Publication No. 116373/1984. In this method, the laser beam is concentrated and irradiated to an irradiated object disposed in vacuum to emit vaporized particles. So, the vaporized particles are deposited on the base material. The vaporized particles are emitted by the high density energy of the concentrated laser beam under high vacuum. Therefore, the mixing of impurities of inert gas into the film is remarkably reduced.

Concerning the above method, it is the serious problem that the non-charged particles (hereinafter described as droplets) are contained in the film. The particle diameter of the droplets is in the range of 1µm to several 10µm. When the droplets are contained in the film, the surface condition of the film, especially, smoothness of the film is remarkably deteriorated. Furthermore, the film density is deteriorated. When the droplets are contained in the electric conductor thin film or the magnetic thin film, the materiality such as the electric conductivity or the magnetism is remarkably deteriorated.

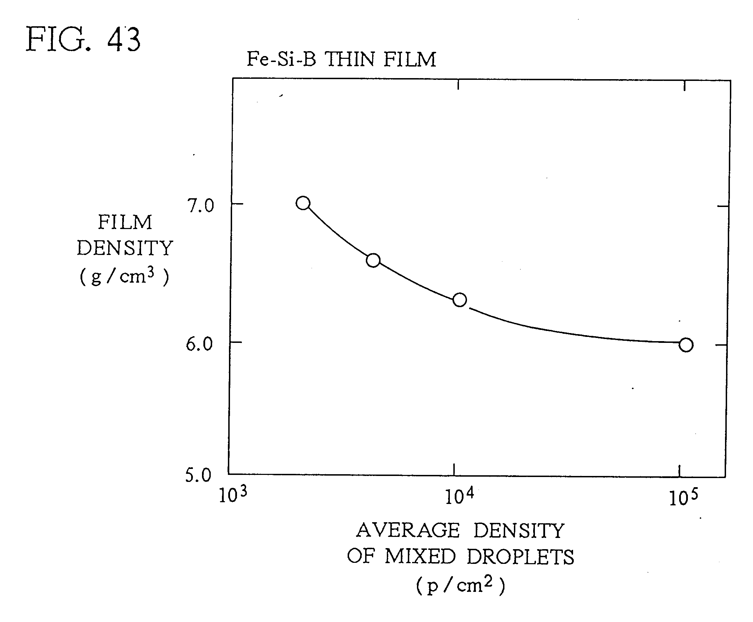

For example, Figure 43 shows the relationship between the average density of the mixed droplets and the density of Fe-Si-B film. As shown in Figure 43, when the average density of the mixed droplets is 10⁵p/cm², the film density is 6.0g/cm³. This value is about 83% of the bulk value (7.2g/cm³), so the film is found to be porous. The coercive force of the film is 13(Oe). When the film is applied to the torque sensor, the sensor sensitivity is deteriorated. When the average density of the mixed droplets is 2 x 10³p/cm², the film density is 7.0g/cm³. This value is about 97% of the bulk value, so the film is found to be dense. The coercive force of the film is decreased to 5(Oe). The film can be remarkably reduced its coercive force as compared with the former one.

The apparatus for preventing the droplets from mixing into the film is disclosed in J. Vac. Sci. Technol. B3(4), Jul/Aug 1985, American Vacuum Society. The apparatus is to prevent the droplets from mixing into the film by using the speed difference of the evaporated particles of ion, neutral particles, clusters, and the droplets. In the apparatus, a shutter which is controlled to open and close by the delay circuit is disposed between the irradiated object and the base material. The delay time from the irradiation time of the pulse laser is set on the delay circuit. After the irradiation of the pulse laser, the shutter has opened for the predetermined time to make ion, the neutral particles, and the clusters pass through. Then, the shutter has closed not to make the droplets pass through since the delay time of the delay circuit is set as the predetermined value. Therefore, the mixing of the droplets into the film is prevented.

In the above apparatus, as the delay time after the irradiation of the pulse laser becomes shorter, the average density of the mixed droplets becomes lower. When the delay time is too short, ion, the neutral particles and the clusters cannot be reached on the base material. Therefore, the film formation speed becomes slower.

The speed of the droplets is generally slower than that of the clusters. The speed of the clusters is generally slower than that of the neutral particles. The speed of the neutral particles is generally slower than that of ion. However, each particle group has wide speed ranges, so it is impossible to determine the above classification. Therefore, in the aforementioned apparatus, the mixing amount of the droplets cannot be fully reduced since the apparatus makes use of the speed difference of the evaporated particles. As disclosed in the aforementioned document, the average density of the mixed droplets is varied from 10⁶p/cm² to 10⁵p/cm² by using the shutter. However, the obtained film is not fully dense.

The above method is to prevent the droplets from mixing into the film since the droplets which are eliminated from the irradiated object are prevented from reaching the base material by means of the mechanical and electrical method. However, in the method, the droplets are fully prevented from mixing into the film.

Inventors of the present invention got an idea that the droplets are not generated from the irradiated object since the irradiation method of the laser beam is changed. Then, we studied the relationship between the irradiation method of the laser beam and the generation of the droplets from the irradiated object.

"Laser Abrasion for Materials Synthesis, vol. 191, Material Research Society, symposium proceedings" discloses the relationship between the generation of the droplets from the irradiated object and the incident angle when the laser beam is irradiated to the irradiated object. This is the result when a superconductor thin film (an oxide thin film) is formed by the laser beam. When the concentrated laser beam is irradiated to the irradiated object, the incident angle becomes smaller, the droplets are more generated from the irradiated object. Therefore, the generation of the droplets from the irradiated object is effectively reduced by setting the incident angle as more than 45 degrees when the laser beam is irradiated to the irradiated object.

In case of forming a metal thin film by the laser beam, the inventors of the present invention have found that the generation of the droplets from the irradiated object cannot be reduced by setting the incident angle as more than 45 degrees when the laser beam is irradiated to the irradiated object.

### SUMMARY OF THE INVENTION

Concerning the above problem, it is an object of the present invention is to provide a method for forming a metal thin film by using a laser beam in which the generation of the droplets from the irradiated object is reduced by adjusting the incident angle when the laser beam is irradiated to the irradiated object. Therefore, the droplets cannot be mixed into the film.

Inventors supposed that a metal is different from a nonmetal (e.g. an oxide) in the materiality such as the melting point or the heat conductivity, so the incident angle suitable for reducing the generation of the droplets is different. We studied the relationship between the generation of the droplets and the incident angle, and finally completed the present invention. The present invention is to provide a method for forming a film by a laser beam in which the laser beam is concentrated and irradiated to the irradiated object disposed in a vacuum vessel to emit the evaporated particles so that the evaporated particles are deposited on the base material disposed opposedly with respect to the irradiated object. It is characterized in that the irradiated object is made of metal, and the laser beam is irradiated to the irradiated object at the incident angle of less than 43 degrees.

The above incident angle is made by that a central optical axis of the laser beam irradiated into the surface of the irradiated object is crossed with a normal line of the surface of the irradiated object.

In the method for forming the film by using the laser beam according to the present invention, the incident angle is set as less than 43 degrees when the laser beam is irradiated to the irradiated object made of metal. Therefore, the generation of the droplets from the irradiated object is effectively reduced, so that the average density of the mixed droplets in the film can be lowered.

No effect of reducing the generation of the droplets depends on the change of the power density of the laser beam. This is described as follows. The power density of the laser beam is changed by that the incident angle of the laser beam is constant, and that the lens is adjusted. When the generation amount of the droplets are examined, the power density of the laser beam is increasing, the generation amount of the droplets is increasing. On the while, when the incident angle is low, the power density of the laser beam is increasing, but the generation amount of the droplets is decreased.

### BRIEF DESCRIPTION OF THE DRAWINGS

A more complete appreciation of the present invention and many of its advantages will be readily obtained as the same becomes better understood by reference to the following detailed description when considered in connection with the accompanying drawings and detailed specification, all of which forms a part of the disclosure:

Figure 1 is a diagram for showing an apparatus for forming a film by a laser beam according to the present invention.

Figure 2 is a diagram for showing an incident angle according to the First Preferred Embodiment.

Figure 3 is a graph for showing the relationship between the incident angle ϑ and the average density of the mixed droplets in the Ni thin film according to the First Preferred Embodiment.

Figure 4(a) is a SEM photograph (magnification x 200) and Figure 4(b) is a SEM photograph (magnification x 2000) for showing the particle structure on the surface of the Ni thin film under the condition that the incident angle ϑ is 45 degrees according to the First Preferred Embodiment.

Figure 5(a) is a SEM photograph (magnification x 200) and Figure 5(b) is a SEM photograph (magnification x 2000) for showing the particle structure on the surface of the Ni thin film under the condition that the incident angle ϑ is 30 degrees according to the First Preferred Embodiment.

Figure 6(a) is a SEM photograph (magnification x 200) and Figure 6(b) is a SEM photograph (magnification x 2000) for showing the particle structure on the surface of the Ni thin film under the condition that the incident angle ϑ is 20 degrees according to the First Preferred Embodiment.

Figure 7(a) is a SEM photograph (magnification x 200) and Figure 7(b) is a SEM photograph (magnification x 2000) for showing the particle structure on the surface of the irradiated object (Ni) after the irradiation of the laser beam under the condition that the incident angle ϑ is 45 degrees according to the First Preferred Embodiment.

Figure 8(a) is a SEM photograph (magnification x 200) and Figure 8(b) is a SEM photograph (magnification x 2000) for showing the particle structure on the surface of the irradiated object (Ni) after the irradiation of the laser beam under the condition that the incident angle ϑ is 30 degrees according to the First Preferred Embodiment.

Figure 9(a) is a SEM photograph (magnification x 200) and Figure 9(b) is a SEM photograph (magnification x 2000) for showing the particle structure on the surface of the irradiated object (Ni) after the irradiation of the laser beam under the condition that the incident angle ϑ is 20 degrees according to the First Preferred Embodiment.

Figure 10 is a graph for showing the relationship between the incident angle ϑ and the average density of the mixed droplets in the Fe thin film according to the Second Preferred Embodiment.

Figure 11(a) is a SEM photograph (magnification x 200) and Figure 11(b) is a SEM photograph (magnification x 2000) for showing the particle structure on the surface of the Fe thin film under the condition that the incident angle ϑ is 45 degrees according to the Second Preferred Embodiment.

Figure 12(a) is a SEM photograph (magnification x 200) and Figure 12(b) is a SEM photograph (magnification x 2000) for showing the particle structure on the surface of the Fe thin film under the condition that the incident angle ϑ is 30 degrees according to the Second Preferred Embodiment.

Figure 13(a) is a SEM photograph (magnification x 200) and Figure 13(b) is a SEM photograph (magnification x 2000) for showing the particle structure on the surface of the Fe thin film under the condition that the incident angle ϑ is 20 degrees according to the Second Preferred Embodiment.

Figure 14(a) is a SEM photograph (magnification x 200) and Figure 14(b) is a SEM photograph (magnification x 2000) for showing the particle structure on the surface of the irradiated object (Fe) after the irradiation of the laser beam under the condition that the incident angle ϑ is 45 degrees according to the Second Preferred Embodiment.

Figure 15(a) is a SEM photograph (magnification x 200) and Figure 15(b) is a SEM photograph (magnification x 2000) for showing the particle structure on the surface of the irradiated object (Fe) after the irradiation of the laser beam under the condition that the incident angle ϑ is 30 degrees according to the Second Preferred Embodiment.

Figure 16(a) is a SEM photograph (magnification x 200) and Figure 16(b) is a SEM photograph (magnification x 2000) for showing the particle structure on the surface of the irradiated object (Fe) after the irradiation of the laser beam under the condition that the incident angle ϑ is 20 degrees according to the Second Preferred Embodiment.

Figure 17 is a graph for showing the relationship between the incident angle ϑ and the average density of the mixed droplets in the Cr thin film according to the Third Preferred Embodiment.

Figure 18(a) is a SEM photograph (magnification x 200) and Figure 18(b) is a SEM photograph (magnification x 2000) for showing the particle structure on the surface of the Cr thin film under the condition that the incident angle ϑ is 45 degrees according to the Third Preferred Embodiment.

Figure 19(a) is a SEM photograph (magnification x 200) and Figure 19(b) is a SEM photograph (magnification x 2000) for showing the particle structure on the surface of the Cr thin film under the condition that the incident angle ϑ is 30 degrees according to the Third Preferred Embodiment.

Figure 20(a) is a SEM photograph (magnification x 200) and Figure 20(b) is a SEM photograph (magnification x 2000) for showing the particle structure on the surface of the Cr thin film under the condition that the incident angle ϑ is 20 degrees according to the Third Preferred Embodiment.

Figure 21(a) is a SEM photograph (magnification x 200) and Figure 21(b) is a SEM photograph (magnification x 2000) for showing the particle structure on the surface of the irradiated object (Cr) after the irradiation of the laser beam under the condition that the incident angle ϑ is 45 degrees according to the Third Preferred Embodiment.

Figure 22(a) is a SEM photograph (magnification x 200) and Figure 22(b) is a SEM photograph (magnification x 2000) for showing the particle structure on the surface of the irradiated object (Cr) after the irradiation of the laser beam under the condition that the incident angle ϑ is 30 degrees according to the Third Preferred Embodiment.

Figure 23(a) is a SEM photograph (magnification x 200) and Figure 23(b) is a SEM photograph (magnification x 2000) for showing the particle structure on the surface of the irradiated object (Cr) after the irradiation of the laser beam under the condition that the incident angle ϑ is 20 degrees according to the Third Preferred Embodiment.

Figure 24 is a graph for showing the relationship between the incident angle ϑ and the average density of the mixed droplets in the Mo thin film according to the Fourth Preferred Embodiment.

Figure 25(a) is a SEM photograph (magnification x 200) and Figure 25(b) is a SEM photograph (magnification x 2000) for showing the particle structure on the surface of the Mo thin film under the condition that the incident angle ϑ is 60 degrees according to the Fourth Preferred Embodiment.

Figure 26(a) is a SEM photograph (magnification x 200) and Figure 26(b) is a SEM photograph (magnification x 2000) for showing the particle structure on the surface of the Mo thin film under the condition that the incident angle ϑ is 45 degrees according to the Fourth Preferred Embodiment.

Figure 27(a) is a SEM photograph (magnification x 200) and Figure 27(b) is a SEM photograph (magnification x 2000) for showing the particle structure on the surface of the Mo thin film under the condition that the incident angle ϑ is 30 degrees according to the Fourth Preferred Embodiment.

Figure 28(a) is a SEM photograph (magnification x 200) and Figure 28(b) is a SEM photograph (magnification x 2000) for showing the particle structure on the surface of the irradiated object (Mo) after the irradiation of the laser beam under the condition that the incident angle ϑ is 60 degrees according to the Fourth Preferred Embodiment.

Figure 29(a) is a SEM photograph (magnification x 200) and Figure 29(b) is a SEM photograph (magnification x 2000) for showing the particle structure on the surface of the irradiated object (Mo) after the irradiation of the laser beam under the condition that the incident angle ϑ is 45 degrees according to the Fourth Preferred Embodiment.

Figure 30(a) is a SEM photograph (magnification x 200) and Figure 30(b) is a SEM photograph (magnification x 2000) for showing the particle structure on the surface of the irradiated object (Mo) after the irradiation of the laser beam under the condition that the incident angle ϑ is 30 degrees according to the Fourth Preferred Embodiment.

Figure 31 is a graph for showing the relationship between the incident angle ϑ and the average density of the mixed droplets in the W thin film according to the Fifth Preferred Embodiment.

Figure 32(a) is a SEM photograph (magnification x 200) and Figure 32(b) is a SEM photograph (magnification x 2000) for showing the particle structure on the surface of the W thin film under the condition that the incident angle ϑ is 60 degrees according to the Fifth Preferred Embodiment.

Figure 33(a) is a SEM photograph (magnification x 200) and Figure 33(b) is a SEM photograph (magnification x 2000) for showing the particle structure on the surface of the W thin film under the condition that the incident angle ϑ is 45 degrees according to the Fifth Preferred Embodiment.

Figure 34(a) is a SEM photograph (magnification x 200) and Figure 34(b) is a SEM photograph (magnification x 2000) for showing the particle structure on the surface of the W thin film under the condition that the incident angle ϑ is 30 degrees according to the Fifth Preferred Embodiment.

Figure 35(a) is a SEM photograph (magnification x 200) and Figure 35(b) is a SEM photograph (magnification x 2000) for showing the particle structure on the surface of the irradiated object (W) after the irradiation of the laser beam under the condition that the incident angle ϑ is 60 degrees according to the Fifth Preferred Embodiment.

Figure 36(a) is a SEM photograph (magnification x 200) and Figure 36(b) is a SEM photograph (magnification x 2000) for showing the particle structure on the surface of the irradiated object (W) after the irradiation of the laser beam under the condition that the incident angle ϑ is 45 degrees according to the Fifth Preferred Embodiment.

Figure 37(a) is a SEM photograph (magnification x 200) and Figure 37(b) is a SEM photograph (magnification x 2000) for showing the particle structure on the surface of the irradiated object (W) after the irradiation of the laser beam under the condition that the incident angle ϑ is 30 degrees according to the Fifth Preferred Embodiment.

Figure 38 is a graph for showing the relationship between the melting point of the irradiated object and critical incident angle ϑ*c* .

Figure 39 is a diagonal view for showing the base material holding device when the film for magneto-striction type torque sensor is formed on the torque transmission axis according to the Sixth Preferred Embodiment.

Figure 40 is a diagonal view for showing the method for detecting the transmission torque concerning the torque transmission axis on which the magnetic metal film is formed according to the Sixth Preferred Embodiment.

Figure 41 is a graph for showing the result of detecting the transmission torque concerning the film for the torque transmission sensor under the condition that the incident angle is 30 degrees and 45 degrees according to the Sixth Preferred Embodiment.

Figure 42 is a bar chart for showing the result of detecting the axle circumferential transfer of the sensor sensitivity concerning the film for the torque transmission sensor under the condition that the incident angle ϑ is 30 degrees and 45 degrees according to the Sixth Preferred Embodiment.

Figure 43 is a graph for showing the relationship between the average density of the mixed droplets and the density of Fe-Si-B film.

### DETAILED DESCRIPTION OF THE PREFERRED EMBODIMENTS

Having generally described the present invention, a further understanding can be obtained by reference to the specific preferred embodiments which are provided herein for purposes of illustration only and are not intended to limit the scope of the appended claims.

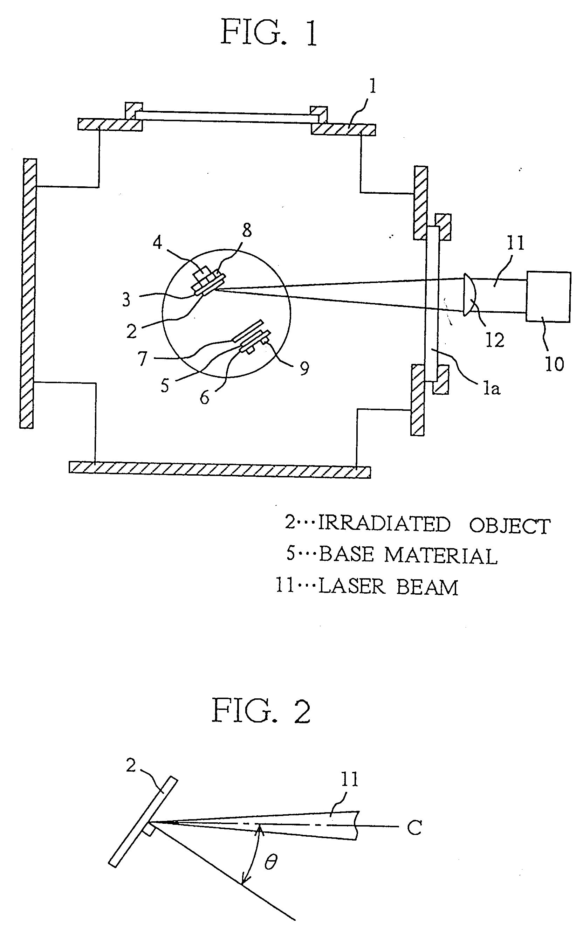

The Preferred Embodiments according to the present invention will be hereinafter described with reference to Figures 1 through 43.

The apparatus for forming a film by a laser beam according to the present invention is described with reference to Figure 1. In a vacuum chamber 1 comprising a proof-pressure vessel in which the predetermined vacuum condition is maintained, an irradiated object holder 3 for holding an irradiated object 2 is rotatably disposed by a motor 4. The irradiated object holder 3 can be rocked with the motor 4 to vary an incident angle of a laser beam 11. At the position opposed to the irradiated object holder 3 in the vacuum chamber 1, a base material holder 6 for holding a base material 5 is disposed by way of a movable shutter 7. To obtain a stable film, the movable shutter 7 closed until the laser beam becomes stable from the beginning of the operation of a laser beam generator 10. The irradiated object 2 held by the irradiated object holder 3 is grounded, and the bias voltage is applied to the base material 5 held by the base material holder 6. Therefore, the speed of charged particles is controlled, and it is also possible to control the speed of film-formation. A heater 8 is added to the irradiated object holder 3, and a heater 9 is added to the base material holder 6. Therefore, it is possible to make the temperature of the irradiated object 2 and the base material 5 desirable.

The laser beam generator 10 emits the laser beam 11. The laser beam 11 passes through a light-concentrated lens (a quartz lens) 12, and then it is introduced into the vacuum chamber 1 by way of a quartz window 1a disposed at the side surface of the vacuum chamber 1. The power density of the laser beam 11 irradiated to the irradiated object 2 can be controlled by adjusting the focal distance of the light-concentrated lens 12.

### First Preferred Embodiment

A First Preferred Embodiment employed the above-described apparatus to form the Ni thin film as follows.

The irradiated object 2 was Ni in which the melting point was 1453 degrees. The base material 5 was Si wafer. The laser beam 11 was KrF excimer laser in which the wave length was 248nm, the pulse duration was 15nsec, the repeated frequency was 100Hz, and the pulse energy was 250mJ. The pressure in the vacuum chamber 1 was less than 1 x 10⁻⁶ Torr in forming the film. The power density of the laser beam on the irradiated object 2 was 7J/cm². The distance between the irradiated object 2 and the base material 5 was 25mm. The bias voltage of the base material 5 was OV. The rotation speed of the motor 4 was 50rpm. The temperature of the irradiated object 2 and the base material 5 was the room temperature. The irradiation pulse number was set in such a manner that the thickness of the film was 2µm. Under these circumstances, the incident angle ϑ of the laser beam 11 was varied to 10, 20, 30, 38 and 45 degrees to form the Ni thin film. As shown in Figure 2, the incident angle ϑ was made by that a central optical axis C of the laser beam 11 irradiated into the surface of the irradiated object 2 was crossed with a normal line of the surface of the irradiated object 2.

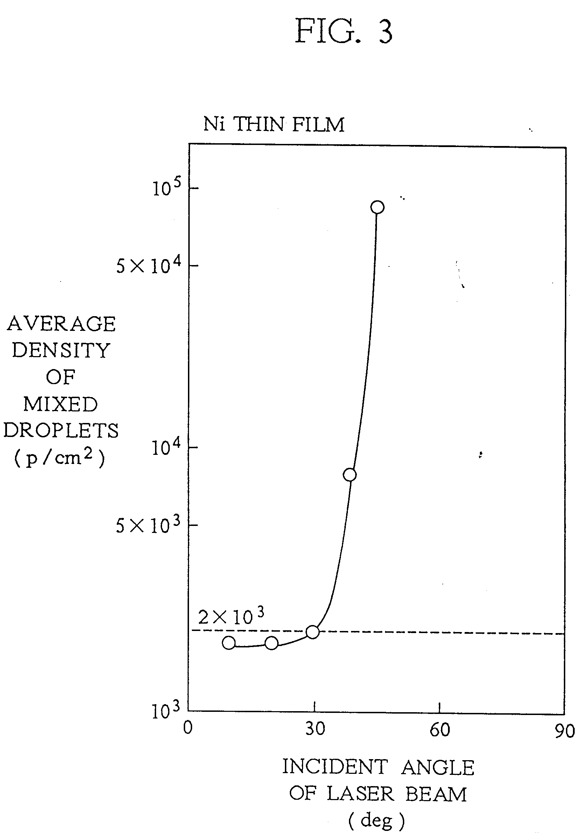

Concerning each Ni thin film made by varying the incident angle ϑ , the average density of the mixed droplets was calculated from the SEM photographs. The result was shown in Figure 3. As seen from Figure 3, the incident angle became smaller, the average density of the mixed droplets became lower. When the incident angle ϑ was less than 30 degrees, the average density of the mixed droplets was less than 2 x 10³p/cm². When the average density of the mixed droplets was 2 x 10³p/cm², the film density was 8.5g/cm³. This value was about 95% of the bulk value (8.9g/cm³), so the film was dense. Therefore, the incident angle ϑ was set as less than 30 degrees for forming the dense Ni thin film having the density whose value was more than 95% of the bulk value.

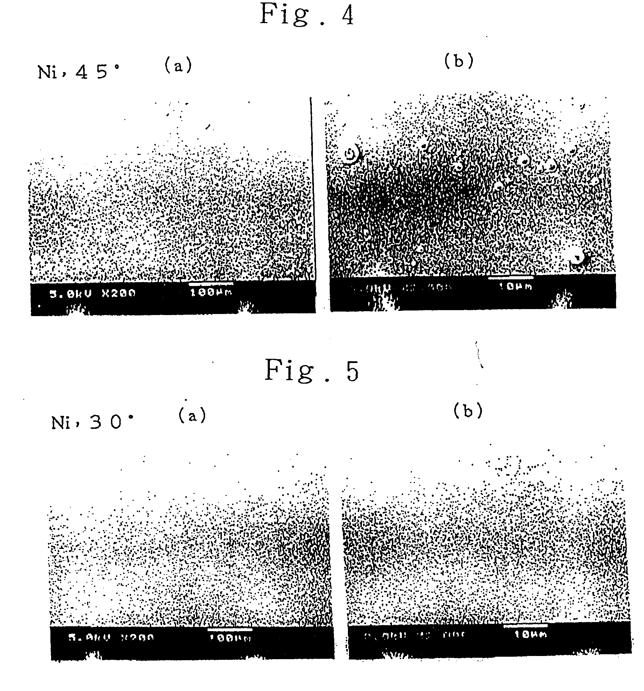

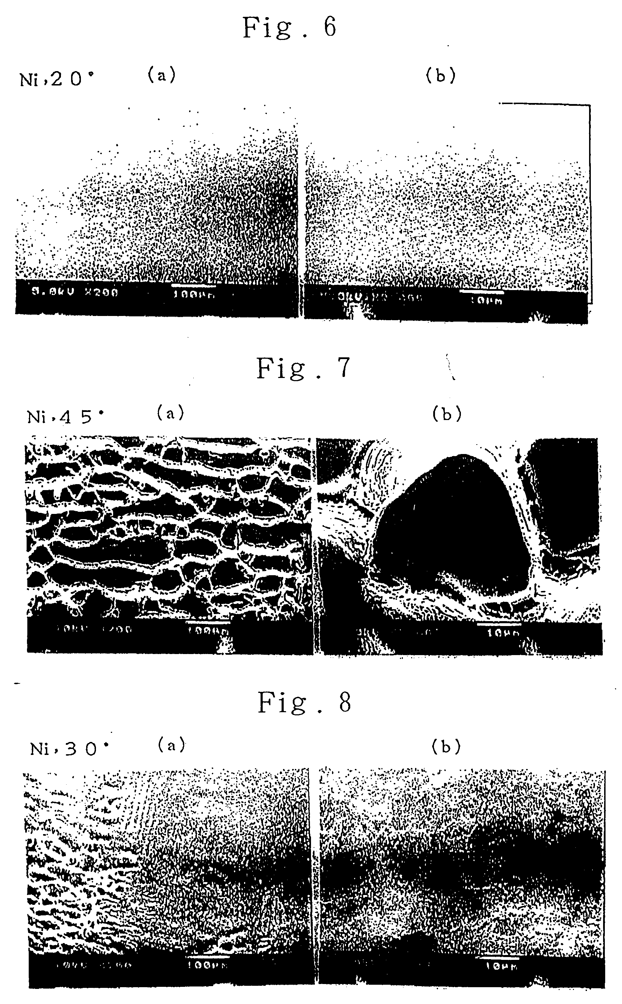

Concerning each Ni thin film formed by varying the incident angle ϑ to 45, 30 and 20 degrees, the surface condition was observed. The particle structure on the surface of each Ni thin film was shown in the SEM photographs in Figures 4 to 6. Figure 4(a) is a SEM photograph (magnification x 200) and Figure 4(b) is a SEM photograph (magnification x 2000) for showing the surface condition of the Ni thin film under the condition that the incident angle ϑ was 45 degrees. Figure 5(a) is a SEM photograph (magnification x 200) and Figure 5(b) is a SEM photograph (magnification x 2000) for showing the surface condition of the Ni thin film under the condition that the incident angle ϑ was 30 degrees. Figure 6(a) is a SEM photograph (magnification x 200) and Figure 6(b) is a SEM photograph (magnification x 2000) for showing the surface condition of the Ni thin film under the condition that the incident angle ϑ was 20 degrees.

As shown in Figure 4, when the incident angle ϑ was 45 degrees, the mixing of the droplets into the Ni thin film was recognized. On the contrary, when the incident angle ϑ was 30 degrees or 20 degrees, the mixing of the droplets into the Ni thin film was rarely recognized as shown in Figures 5 and 6.

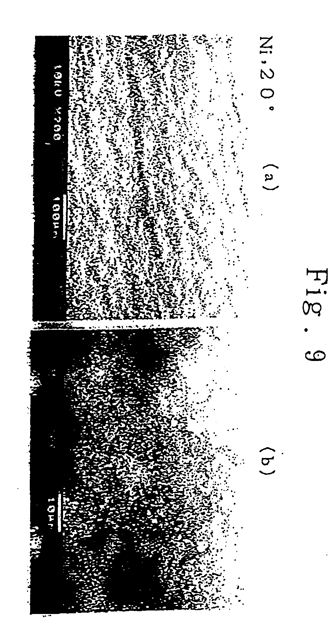

Concerning each Ni thin film formed by varying the incident angle ϑ to 45, 30 and 20 degrees, the surface condition of the irradiated object (Ni) 2 after the irradiation of the laser beam was observed. The particle structure on the surface of each irradiated object (Ni) 2 was shown in the SEM photographs in Figures 7 to 9. Figure 7(a) is a SEM photograph (magnification x 200) and Figure 7(b) is a SEM photograph (magnification x 2000) for showing the surface condition of the irradiated object (Ni) 2 under the condition that the incident angle ϑ was 45 degrees. Figure 8(a) is a SEM photograph (magnification x 200) and Figure 8(b) is a SEM photograph (magnification x 2000) for showing the surface condition of the irradiated object (Ni) 2 under the condition that the incident angle ϑ was 30 degrees. Figure 9(a) is a SEM photograph (magnification x 200) and Figure 9(b) is a SEM photograph (magnification x 2000) for showing the surface condition of the irradiated object (Ni) 2 under the condition that the incident angle ϑ was 20 degrees.

As shown in Figure 7, when the incident angle ϑ was 45 degrees, the rolling structure which caused the generation of the droplets was recognized on the surface of the irradiated object (Ni) 2. On the contrary, when the incident angle was 30 degrees or 20 degrees, the rolling structure was not recognized on the surface of the irradiated object (Ni) 2 as shown in Figures 8 and 9. The incident angle ϑ became smaller, the rolling structure was less recognized. Then, the rolling structure was disappeared at the certain critical angle (in this case, at 30 degrees). The amount of the droplets was largely changed at the critical angle, so it was remarkably reduced at less than the critical angle.

As above described, the generation of the droplets is caused by the rolling structure which is formed on the surface of the irradiated object 2 by the irradiation of the laser beam. The rolling structure is completely diminished by adjusting the incident angle ϑ to less than the critical angle. Therefore, the dense film in which the droplets are not mixed can be formed.

### Second Preferred Embodiment

A Second Preferred Embodiment employed the same compositions and the same manner as described in the First Preferred Embodiment except that the irradiated object 2 was Fe in which the melting point was 1536°C; thereby obtaining the Fe thin film.

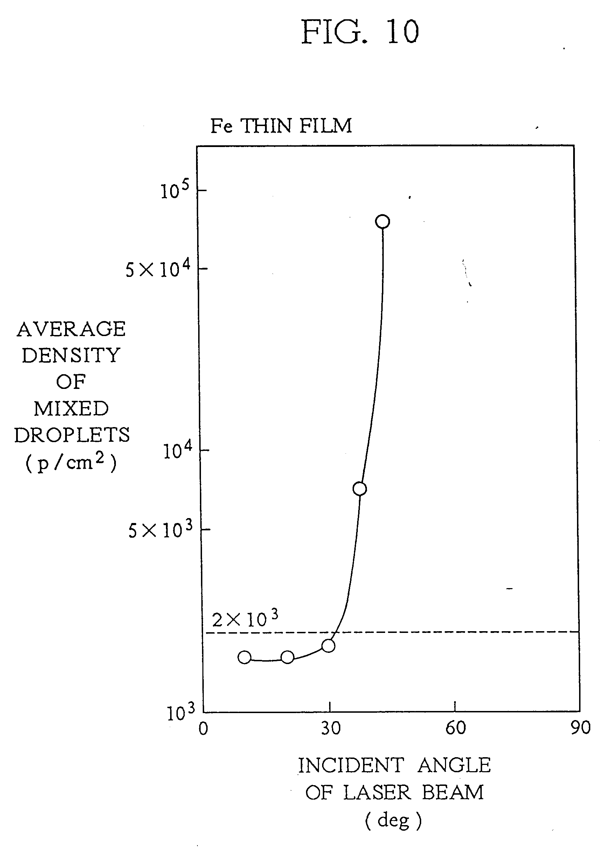

Concerning each Fe thin film made by varying the incident angle ϑ, the average density of the mixed droplets was calculated in the same manner as described in the First Preferred Embodiment. The result was shown in Figure 10. As seen from Figure 10, when the incident angle ϑ was less than 32 degrees, the average density of the mixed droplets was less than 2 x 10³p/cm². When the average density of the mixed droplets was 2 x 10³p/cm², the film density was 7.5g/cm³. This value was about 95% of the bulk value (7.87g/cm³), so the film was dense. Therefore, the incident angle ϑ was set as less than 32 degrees for forming the dense Fe thin film having the density whose value was more than 95% of the bulk value.

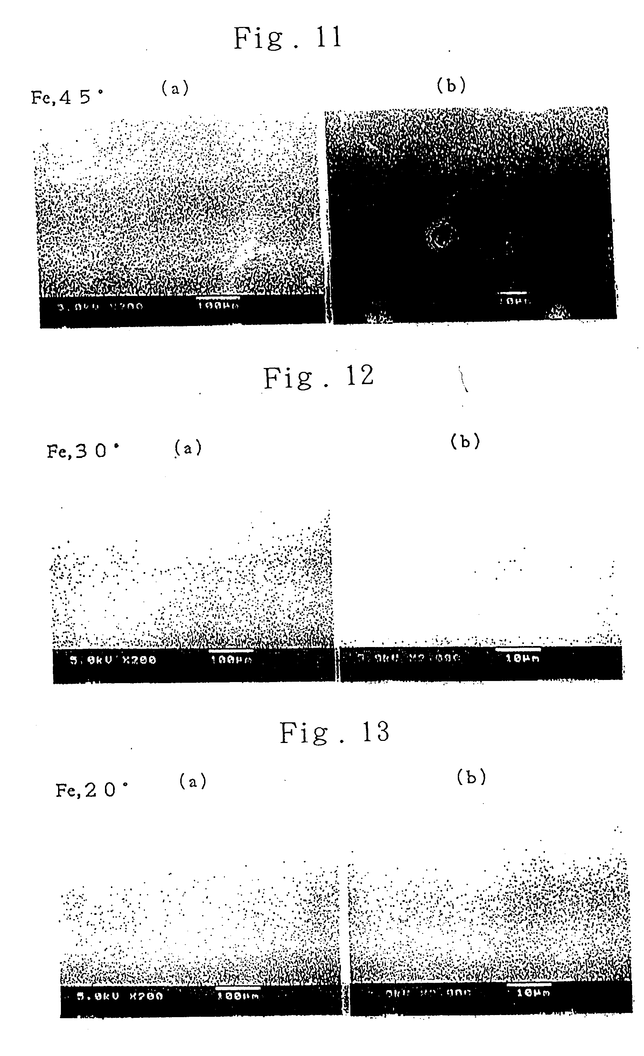

Concerning each Fe thin film formed by varying the incident angle ϑ to 45, 30 and 20 degrees, the surface condition was observed. The particle structure on the surface of each Fe thin film was shown in the SEM photographs in Figures 11 to 13. Figure 11(a) is a SEM photograph (magnification x 200) and Figure 11 (b is a SEM photograph (magnification x 2000) for showing the surface condition of the Fe thin film under the condition that the incident angle was 45 degrees. Figure 12(a) is a SEM photograph (magnification x 200) and Figure 12(b) is a SEM photograph (magnification x 2000) for showing the surface condition of the Fe thin film under the condition that the incident angle was 30 degrees. Figure 13(a) is a SEM photograph (magnification x 200) and Figure 13(b) is a SEM photograph (magnification x 2000) for showing the surface condition of the Fe thin film under the condition that the incident angle was 20 degrees.

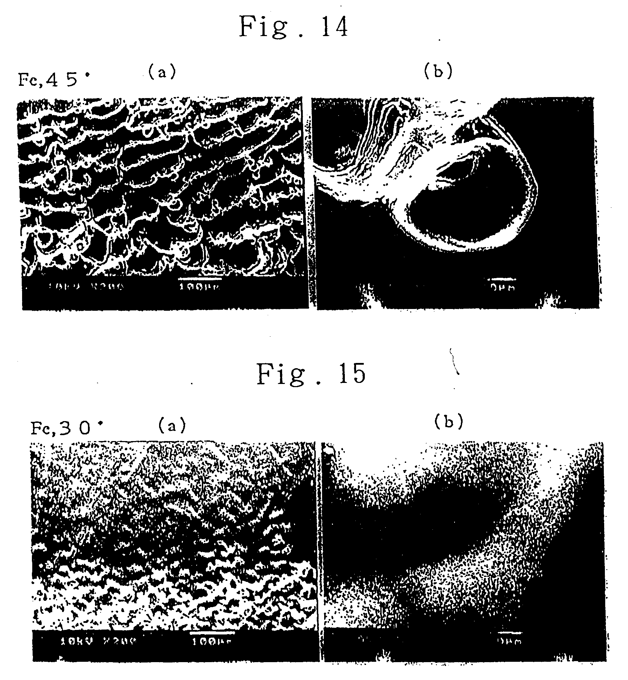

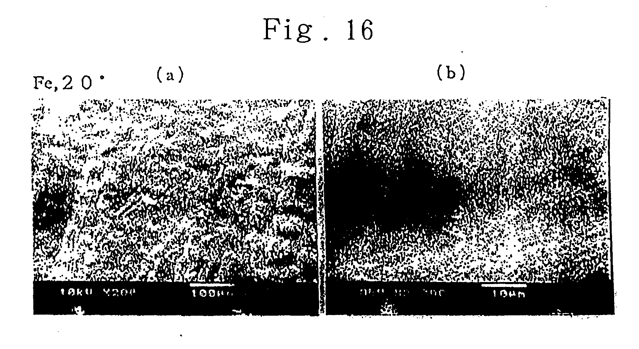

Concerning each Fe thin film formed by varying the incident angle ϑ to 45, 30 and 20 degrees, the surface condition of the irradiated object (Fe) 2 after the irradiation of the laser beam was observed. The particle structure on the surface of each irradiated object (Fe) 2 was shown in the SEM photographs in Figures 14 to 16. Figure 14(a) is a SEM photograph (magnification x 200) and Figure 14(b) is a SEM photograph (magnification x 2000) for showing the surface condition of the irradiated object (Fe) 2 under the condition that the incident angle ϑ was 45 degrees. Figure 15(a) is a SEM photograph (magnification x 200) and Figure 15(b) is a SEM photograph (magnification x 2000) for showing the surface condition of the irradiated object (Fe) 2 under the condition that the incident angle ϑ was 30 degrees. Figure 16(a) is a SEM photograph (magnification x 200) and Figure 16(b) is a SEM photograph (magnification x 2000) for showing the surface condition of the irradiated object (Fe) 2 under the condition that the incident angle ϑ was 20 degrees.

### Third Preferred Embodiment

A Third Preferred Embodiment employed the same compositions and the same manner as described in the First Preferred Embodiment except that the irradiated object 2 was Cr in which the melting point was 1875°C; thereby obtaining the Cr thin film.

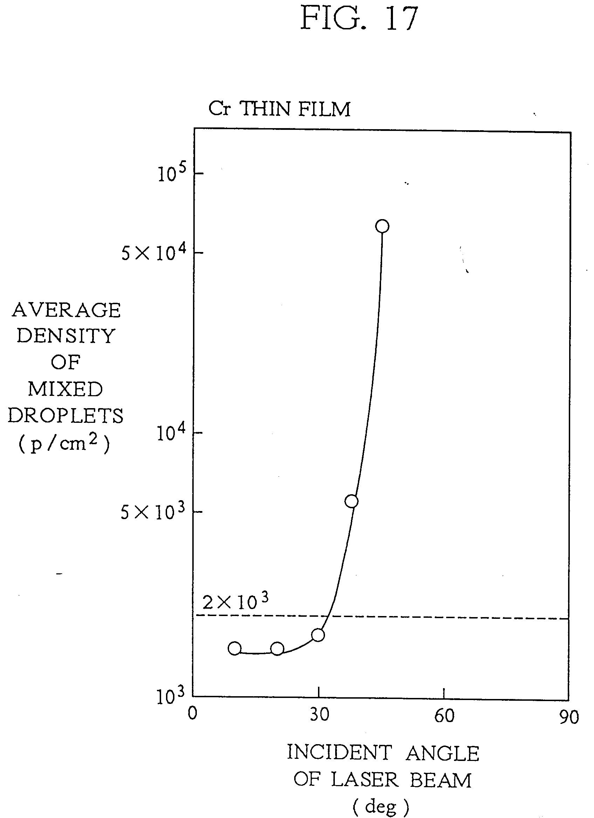

Concerning each Cr thin film made by varying the incident angle ϑ , the average density of the mixed droplets was calculated in the same manner as described in the First Preferred Embodiment. The result was shown in Figure 17. As seen from Figure 17, when the incident angle ϑ was less than 33 degrees, the average density of the mixed droplets was less than 2 x 10³p/cm². When the average density of the mixed droplets was 2 x 10³p/cm², the film density was 6.8g/cm³. This value was about 95% of the bulk value (7.19g/cm³), so the film was dense. Therefore, the incident angle ϑ was set as less than 33 degrees for forming the dense Cr thin film having the density whose value was more than 95% of the bulk value.

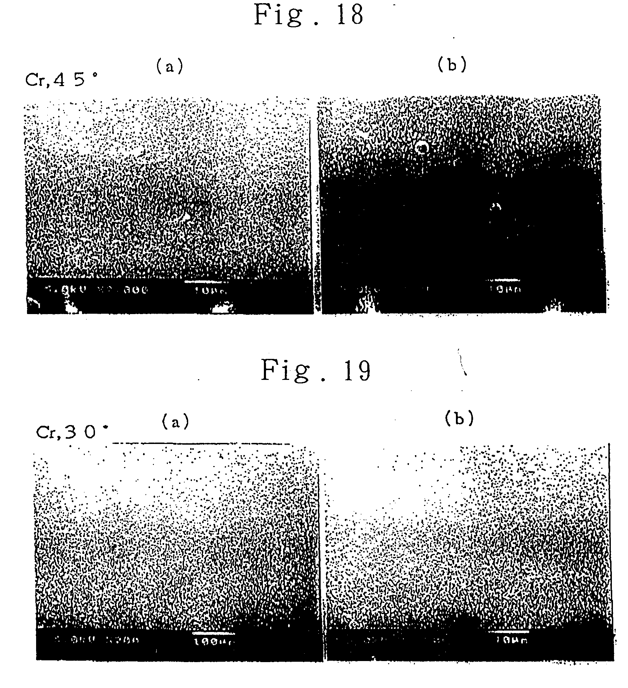

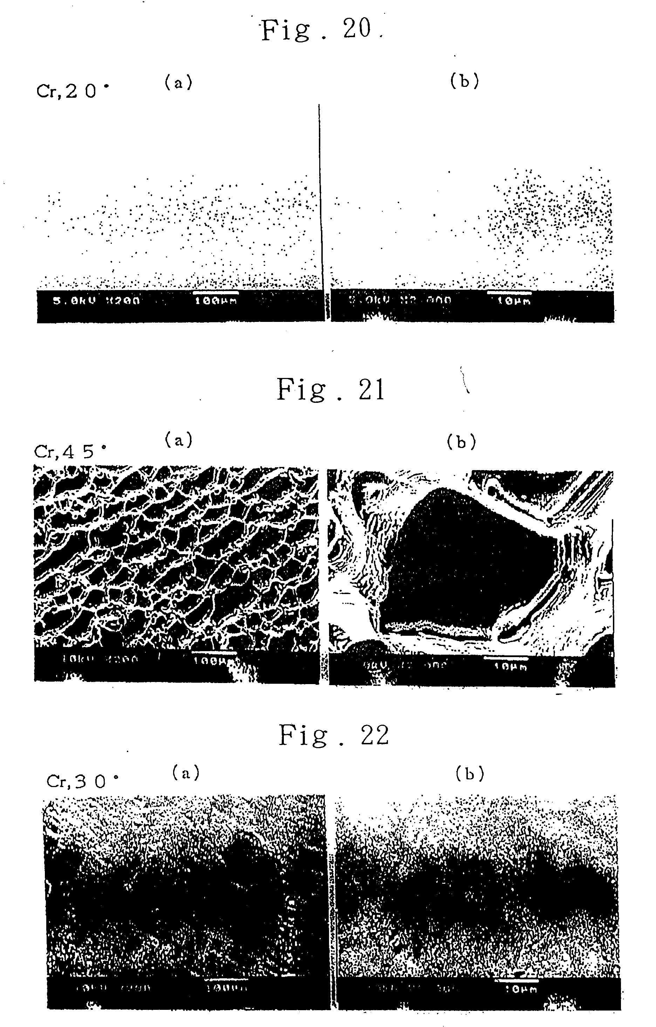

Concerning each Cr thin film formed by varying the incident angle ϑ to 45, 30 and 20 degrees, the surface condition was observed. The particle structure on the surface of each Cr thin film was shown in the SEM photographs in Figures 18 to 20. Figure 18(a) is a SEM photograph (magnification x 200) and Figure 18(b) is a SEM photograph (magnification x 2000) for showing the surface condition of the Cr thin film under the condition that the incident angle was 45 degrees. Figure 19(a) is a SEM photograph (magnification x 200) and Figure 19(b) is a SEM photograph (magnification x 2000) for showing the surface condition of the Cr thin film under the condition that the incident angle was 30 degrees. Figure 20(a) is a SEM photograph (magnification x 200) and Figure 20(b) is a SEM photograph (magnification x 2000) for showing the surface condition of the Cr thin film under the condition that the incident angle was 20 degrees.

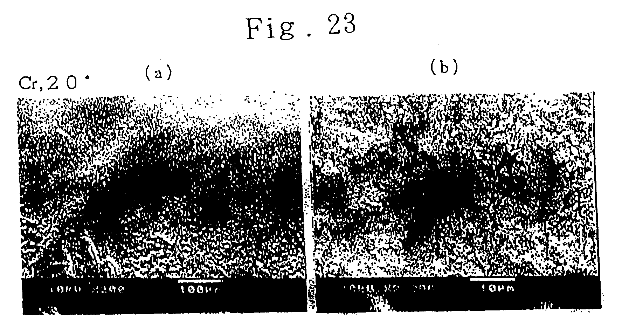

Concerning each Cr thin film formed by varying the incident angle ϑ to 45, 30 and 20 degrees, the surface condition of the irradiated object (Cr) 2 after the irradiation of the laser beam was observed. The particle structure on the surface of each irradiated object (Cr) 2 was shown in the SEM photographs in Figures 21 to 23. Figure 21(a) is a SEM photograph (magnification x 200) and Figure 21(b) is a SEM photograph (magnification x 2000) for showing the surface condition of the irradiated object (Cr) 2 under the condition that the incident angle ϑ was 45 degrees. Figure 22(a) is a SEM photograph (magnification x 200) and Figure 22(b) is a SEM photograph (magnification x 2000) for showing the surface condition of the irradiated object (Cr) 2 under the condition that the incident angle ϑ was 30 degrees. Figure 23(a) is a SEM photograph (magnification x 200) and Figure 23(b) is a SEM photograph (magnification x 2000) for showing the surface condition of the irradiated object (Cr) 2 under the condition that the incident angle ϑ was 20 degrees.

### Fourth Preferred Embodiment

A Fourth Preferred Embodiment employed the same compositions and the same manner as described in the First Preferred Embodiment except that the irradiated object 2 was Mo in which the melting point was 2610°C and that the incident angle ϑ is varied to 20, 30, 45, 52 and 60 degrees; thereby obtaining the Mo thin film.

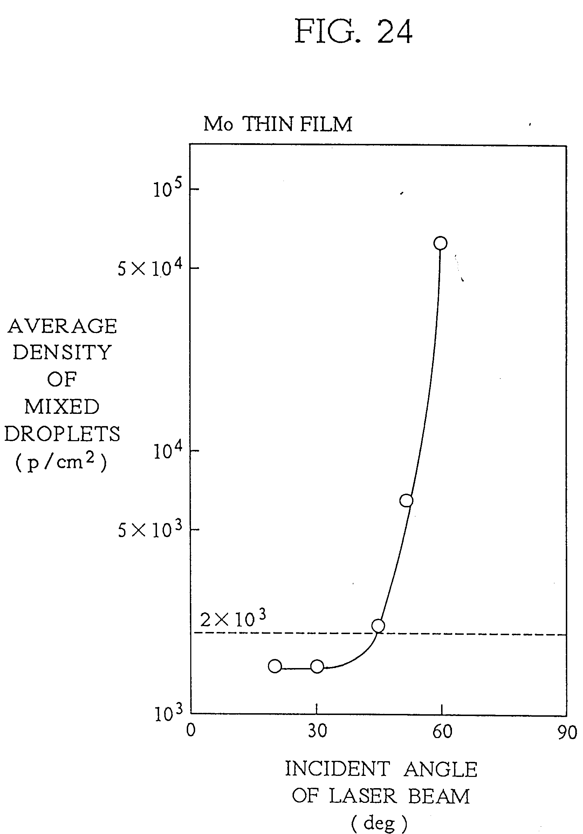

Concerning each Mo thin film made by varying the incident angle ϑ , the average density of the mixed droplets was calculated in the same manner as described in the First Preferred Embodiment. The result was shown in Figure 24. As seen from Figure 24, when the incident angle ϑ was less than 43 degrees, the average density of the mixed droplets was less than 2 x 10³p/cm². When the average density of the mixed droplets was 2 x 10³p/cm², the film density was 9.7g/cm³. This value was about 95% of the bulk value (10.22g/cm³), so the film was dense. Therefore, the incident angle ϑ was set as less than 43 degrees for forming the dense Mo thin film having the density whose value was more than 95% of the bulk value.

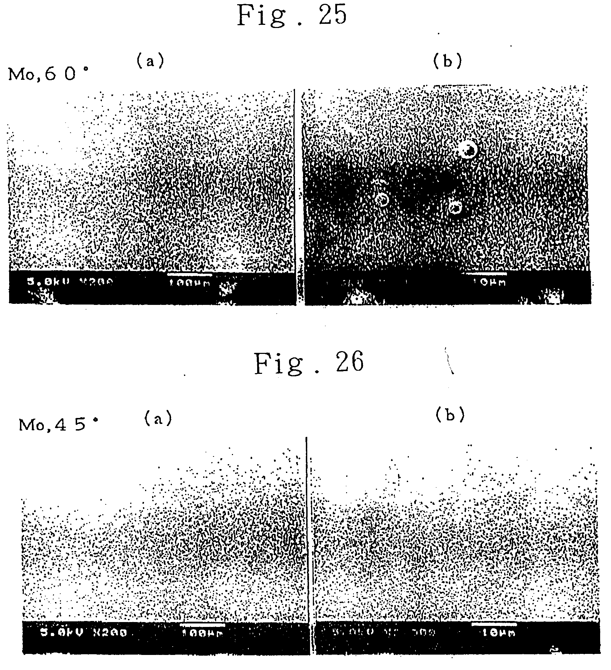

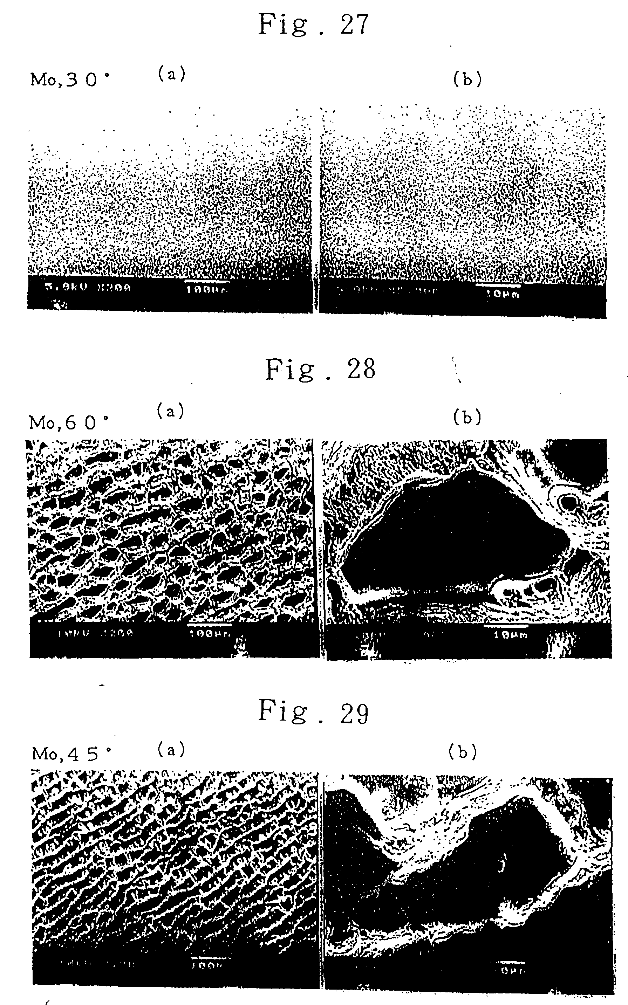

Concerning each Mo thin film formed by varying the incident angle ϑ to 60, 45 and 30 degrees, the surface condition was observed. The particle structure on the surface of each Mo thin film was shown in the SEM photographs in Figures 25 to 27. Figure 25(a) is a SEM photograph (magnification x 200) and Figure 25(b) is a SEM photograph (magnification x 2000) for showing the surface condition of the Mo thin film under the condition that the incident angle was 60 degrees. Figure 26(a) is a SEM photograph (magnification x 200) and Figure 26(b) is a SEM photograph (magnification x 2000) for showing the surface condition of the Mo thin film under the condition that the incident angle was 45 degrees. Figure 27(a) is a SEM photograph (magnification x 200) and Figure 27(b) is a SEM photograph (magnification x 2000) for showing the surface condition of the Mo thin film under the condition that the incident angle was 30 degrees.

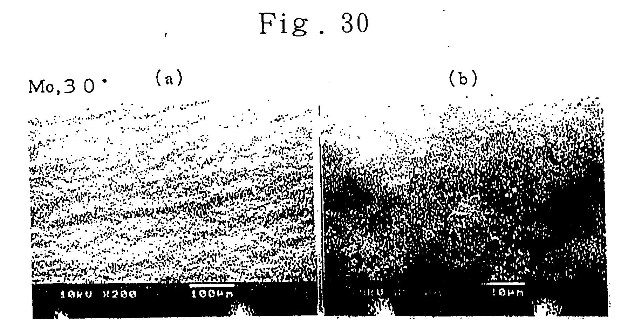

Concerning each Mo thin film formed by varying the incident angle ϑ to 60, 45 and 30 degrees, the surface condition of the irradiated object (Mo) 2 after the irradiation of the laser beam was observed. The particle structure on the surface of each irradiated object (Mo) 2 was shown in the SEM photographs in Figures 28 to 30. Figure 28(a) is a SEM photograph (magnification x 200) and Figure 28(b) is a SEM photograph (magnification x 2000) for showing the surface condition of the irradiated object (Mo) 2 under the condition that the incident angle ϑ was 60 degrees. Figure 29(a) is a SEM photograph (magnification x 200) and Figure 29(b) is a SEM photograph (magnification x 2000) for showing the surface condition of the irradiated object (Mo) 2 under the condition that the incident angle ϑ was 45 degrees. Figure 30(a) is a SEM photograph (magnification x 200) and Figure 30(b) is a SEM photograph (magnification x 2000) for showing the surface condition of the irradiated object (Mo) 2 under the condition that the incident angle ϑ was 30 degrees.

### Fifth Preferred Embodiment

A Fifth Preferred Embodiment employed the same compositions and the same manner as described in the First Preferred Embodiment except that the irradiated object 2 was W in which the melting point was 3410°C and that the incident angle ϑ is varied to 20, 30, 45, 52 and 60 degrees; thereby obtaining the Mo thin film.

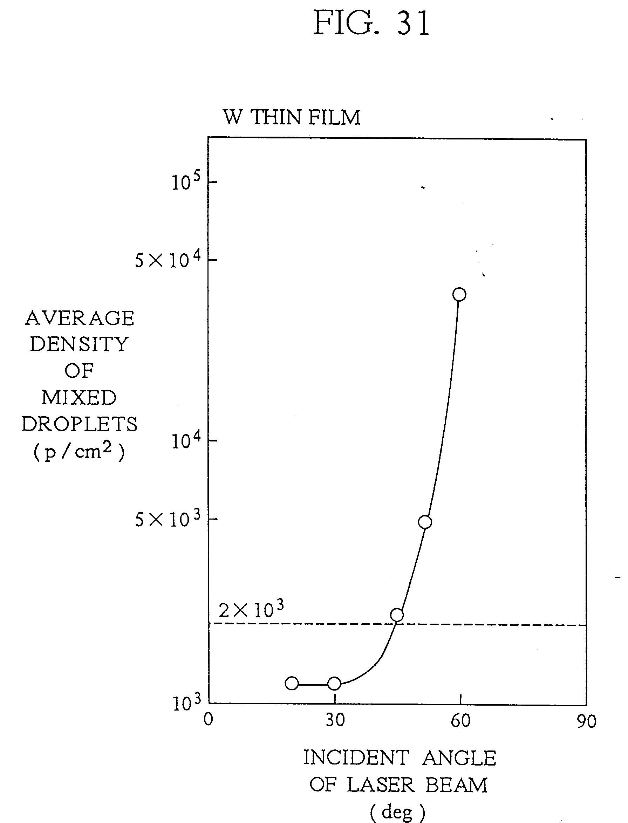

Concerning each W thin film made by varying the incident angle ϑ, the average density of the mixed droplets was calculated in the same manner as described in the First Preferred Embodiment. The result was shown in Figure 31. As seen from Figure 31, when the incident angle ϑ was less than 43 degrees, the average density of the mixed droplets was less than 2 x 10³p/cm². When the average density of the mixed droplets was 2 x 10³p/cm², the film density was 18.3g/cm³. This value was about 95% of the bulk value (19.3g/cm³), so the film was dense. Therefore, the incident angle ϑ was set as less than 43 degrees for forming the dense W thin film having the density whose value was more than 95% of the bulk value.

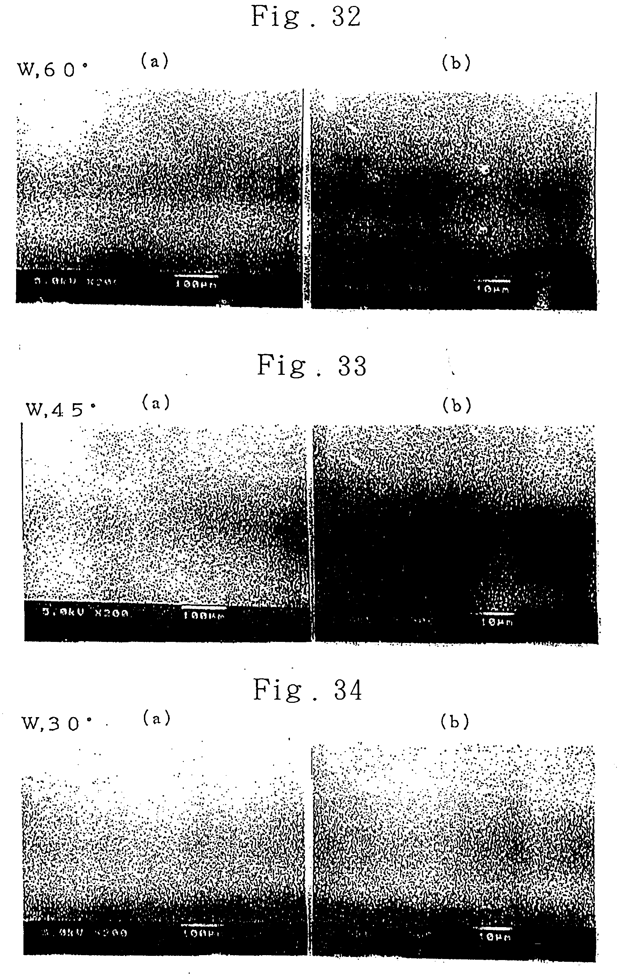

Concerning each W thin film formed by varying the incident angle ϑ to 60, 45 and 30 degrees, the surface condition was observed. The particle structure on the surface of each W thin film was shown in the SEM photographs in Figures 32 to 34. Figure 32(a) is a SEM photograph (magnification x 200) and Figure 32(b) is a SEM photograph (magnification x 2000) for showing the surface condition of the W thin film under the condition that the incident angle ϑ was 60 degrees. Figure 33(a) is a SEM photograph (magnification x 200) and Figure 33(b) is a SEM photograph (magnification x 2000) for showing the surface condition of the W thin film under the condition that the incident angle ϑ was 45 degrees. Figure 34(a) is a SEM photograph (magnification x 200) and Figure 34(b) is a SEM photograph (magnification x 2000) for showing the surface condition of the W thin film under the condition that the incident angle ϑ was 30 degrees.

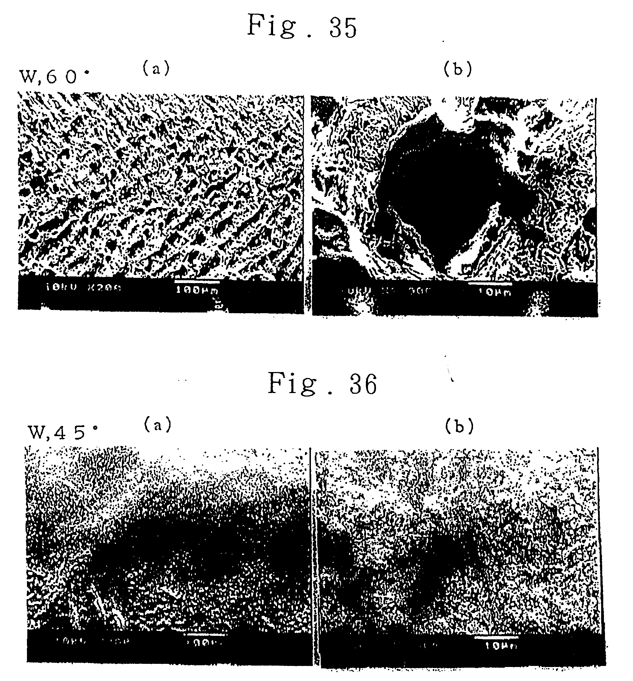

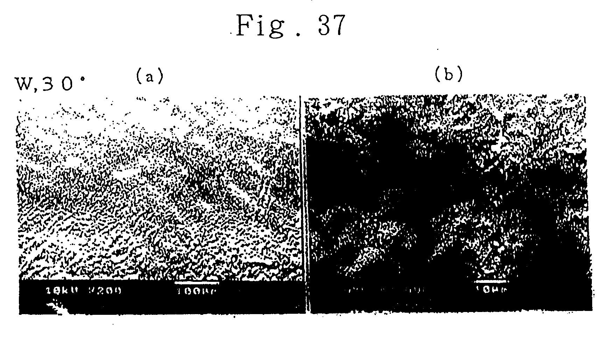

Concerning each W thin film formed by varying the incident angle ϑ to 60, 45 and 30 degrees, the surface condition of the irradiated object (W) 2 after the irradiation of the laser beam was observed. The particle structure on the surface of each irradiated object (W) 2 was shown in the SEM photographs in Figures 35 to 37. Figure 35(a) is a SEM photograph (magnification x 200) and Figure 35(b) is a SEM photograph (magnification x 2000) for showing the surface condition of the irradiated object (W) 2 under the condition that the incident angle ϑ was 60 degrees. Figure 36(a) is a SEM photograph (magnification x 200) and Figure 36(b) is a SEM photograph (magnification x 2000) for showing the surface condition of the irradiated object (W) 2 under the condition that the incident angle ϑ was 45 degrees. Figure 37(a) is a SEM photograph (magnification x 200) and Figure 37(b) is a SEM photograph (magnification x 2000) for showing the surface condition of the irradiated object (W) 2 under the condition that the incident angle ϑ was 30 degrees.

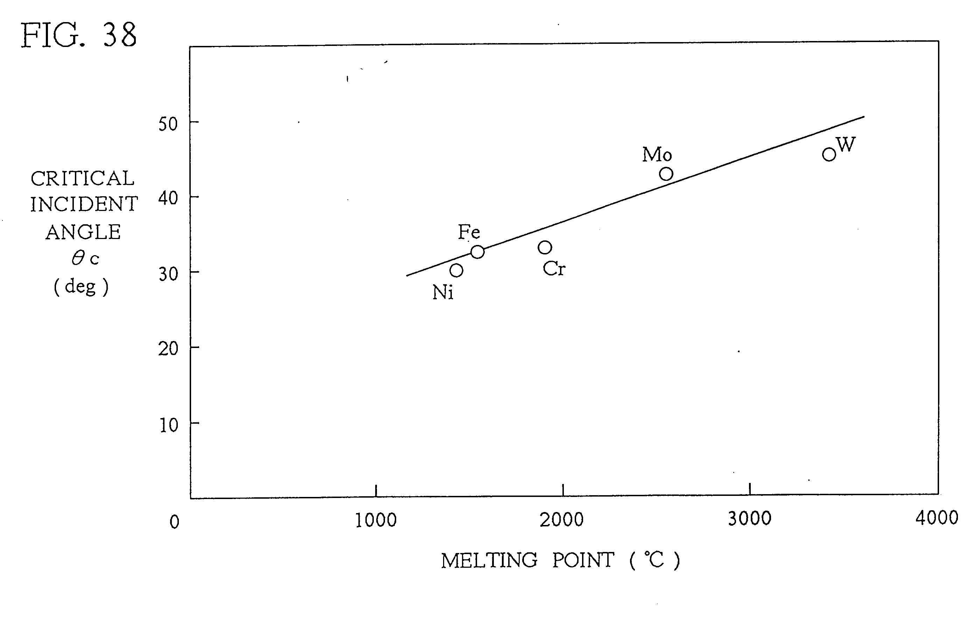

Concerning the above Preferred Embodiments 1 to 5, Figure 38 shows the relationship between the melting point of each irradiated object and the critical incident angle ϑ*c* which is the incident angle ϑ when the average density of the mixed droplets in the film is 2 x 10³p/cm².

As seen from Figure 38, in general, the melting point of the irradiated object became higher, the critical incident angle ϑ*c* became larger. When the irradiated object was the metal in which the melting point was more than 1000°C and less than 2000°C, i.e. Ni (melting point: 1453°C), Fe (melting point: 1536°C) or Cr (melting point: 1875°C), the critical incident angle ϑ*c* was in the range of 30 to 35 degrees. When the irradiated object was the metal in which the melting point was more than 2000°C and less than 3500°C, i.e. Mo (melting point: 2610°C) or W (melting point: 3410°C), the critical incident angle ϑ*c* was in the range of 35 to 43 degrees. Therefore, when the irradiated object is the metal in which the melting point is less than 2000°C it is most preferable that the incident angle ϑ is less than 30 degrees. When the irradiated object is the metal in which the melting point is more than 2000°C, it is most preferable that the incident angle ϑ is less than 35 degrees.

### Sixth Preferred Embodiment

A Sixth Preferred Embodiment employed the same method as described in the First Preferred Embodiment except that the following conditions are different; thereby forming the magneto-striction type torque sensor film comprising Fe-Si-B thin film on the torque transmission axis. The torque transmission axis was SCM400H shaft which comprises Cr-Mo steel shaft, and whose diameter is 35mm.

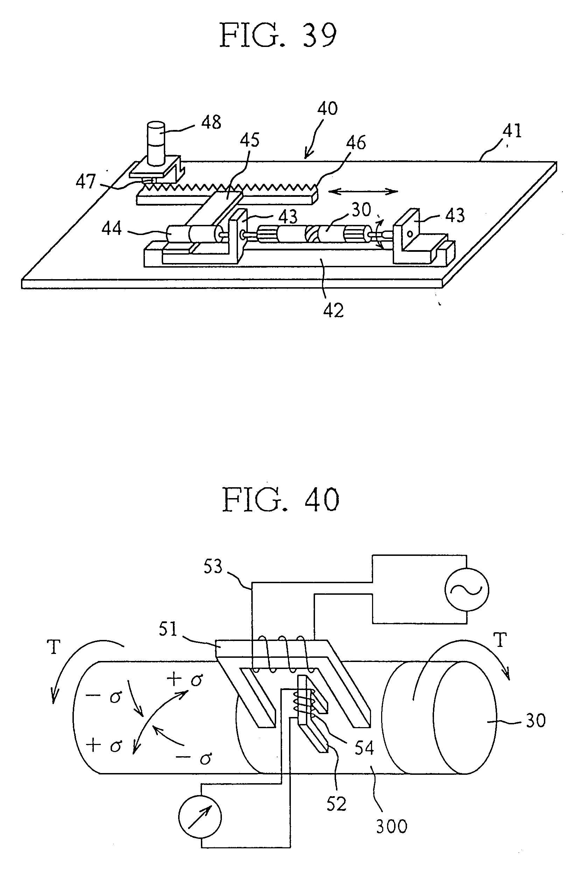

A base material holding device 40 shown in Figure 39 is attached to the above-described apparatus. The base material holding device 40 comprises a base stand 41, a base material holding portion 42 which is slidably attached to the base stand 41, a pair of holding plates 43 which are disposed to the base material holding portion 42 and which axially supports the torque transmission axis 30 rotatably, a first motor 44 which is disposed to the base material holding portion 42 and which rotates the torque transmission axis 30 axially supported to the pair of holding plates 43, a rack portion 46 which is slidably attached to the base stand 41 and which is connected to the base material holding portion 42 by way of a clip 45, a second motor 48 which is fixed to the base stand 41 and which slides the rack portion 46 by means of a pinion portion 47.

The irradiated object 2 was the magnetic metal, Fe₇₅Si₈B₁₇, whose melting point was 1146°C The first motor 44 and the second motor 48 were actuated to rotate and slide the torque transmission axis 30. At this time, the incident angle ϑ was 30 degrees. Then, the torque sensor film 300 having the thickness of 2 µm was formed on the surface of the torque transmission axis 30.

A Comparative Example employed the same conditions as described in the Sixth Preferred Embodiment except that the above incident angle ϑ was 45 degrees, thereby obtaining the other torque-sensor film 300.

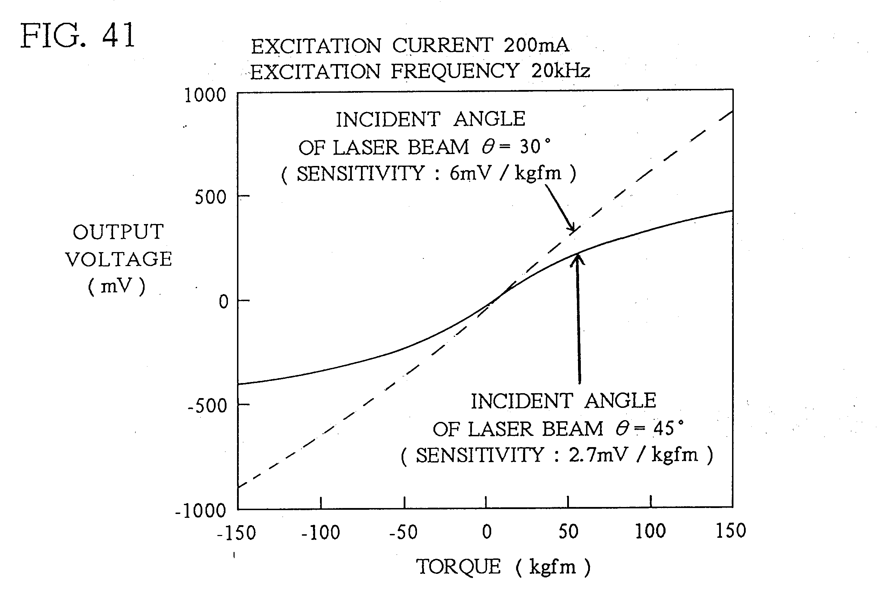

Concerning the torque transmission axis 30, the transmission torque was detected. As shown in figure 40, a U-shaped excitation magnetic core 51 and a detection magnetic core 52 were arranged in order not to contact the torque sensor film 300. The predetermined current in which the excitation current is 200mA and the excitation frequency is 20kHz was flowed into an excitation magnetic coil 53 to generate the constant magnetic field in the atmosphere. Then, the torque having the value of -150 to 150kgfm was applied. At this time, the magnetic field variation (voltage variation) around the torque sensor film 300 was detected by a detected coil 54. The result was shown in Figure 41.

As is obvious from Figure 41, when the incident angle was 45 degrees, the sensor sensitivity of the torque sensor film 300 according to the Comparative Example is 2.7mV/kgfm. On the contrary, when the incident angle ϑ was 30 degrees, the sensor sensitivity of the torque sensor film 300 according to the Sixth Preferred Embodiment is 6mV/kgfm. The sensitivity of the torque sensor film 300 according to the Sixth Preferred Embodiment is more than twice that of the torque sensor film 300 according to the Comparative Example. The torque sensor film 300 according to the Comparative Example contains the droplets having the diameter of 1 to 10 µm, so the clearance between the torque sensor film 300 and the detection magnetic core 52 is about 200 µm. On the contrary, the torque sensor film 300 according to the Sixth Preferred Embodiment contains few droplets, so the clearance between the torque sensor film 300 and the detection magnetic core 52 can be controlled to be about 1 µm. Furthermore, the average density of the mixed droplets in the torque sensor film 300 according to the Comparative Example is 1 x 10⁵p/cm², but the average density of the mixed droplets in the torque sensor film 300 according to the Sixth Preferred Embodiment is 2 x 10³p/cm².

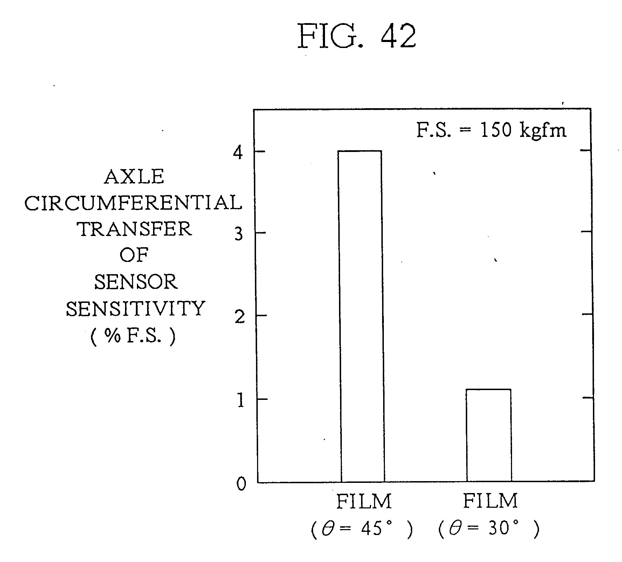

When the maximum value of the added torque is 150kgfm, the axle circumferential transfer concerning the sensor sensitivity is examined. The axle circumferential transfer shows the uniformality of the sensor sensitivity of the torque sensor film 300 in the circumferential direction, and it is detected by calculating the output voltage - torque curve at the circumferential position. The result is shown in Figure 42.

As seen from Figure 42, the axle circumferential transfer according to the Comparative Example is about 4% F.S. On the contrary, the axle circumferential transfer according to the Sixth Preferred Embodiment is about 1% F.S., and it is found to be very uniformal sensor sensitivity in the circumferential direction.

As above described, in the method for forming a film by a laser beam according to the present invention, the incident angle of the laser beam is adjusted to reduce the generation of the droplets from the irradiated object when the laser beam is irradiated, thereby obtaining the metal thin film in which the mixed amount of the droplets is few.

Therefore, it is possible to form the magnetic thin film or the electric conductor thin film which is excellent in the magnetic characteristics or the electric conductive characteristics.

A method for forming a film by a laser beam in which the laser beam is concentrated and irradiated to an irradiated object disposed in a vacuum vessel to emit vaporized particles, and in which the vaporized particles are deposited on a base material opposedly disposed with respect to the irradiated object. The irradiated object is made of metal, and the laser beam is irradiated to the irradiated object at an incident angle of less than 43 degrees. Therefore, the generation of the droplets from the irradiated object is effectively reduced, so that the average density of the mixed droplets in the film can be lowered.

## Claims

1. A method for forming a film by a laser beam in which said laser beam is concentrated and irradiated to an irradiated object disposed in a vacuum vessel to emit vaporized particles, and in which said vaporized particles are deposited on a base material opposedly disposed with respect to said irradiated object characterized in that said irradiated object is made of metal, and said laser beam is irradiated to said irradiated object at an incident angle of less than 43 degrees.

2. A method for forming a film by a laser beam according to claim 1, wherein the melting point of said metal is in the range of 2000°C to 3500°C.

3. A method for forming a film by a laser beam according to claim 2, wherein said incident angle is less than 35 degrees.

4. A method for forming a film by a laser beam in which said laser beam is concentrated and irradiated to an irradiated object disposed in a vacuum vessel to emit vaporized particles, and in which said vaporized particles are deposited on a base material opposedly disposed with respect to said irradiated object characterized in that said irradiated object is made of metal having the melting point of 1000°C to 2000°C, and said laser beam is irradiated to said irradiated object at an incident angle of less than 35 degrees.

5. A method for forming a film by a laser beam according to claim 4, wherein said incident angle is less than 30 degrees.
